# EUROPEAN PATENT APPLICATION

(11) **EP 2 781 927 A1**
(43) Date of publication of application: **24.09.2014**
(21) Application number: 13159945.8
(22) Date of filing: 19.03.2013
(51) Int. Cl.: G01R 31/02, F01N 3/10, F02D 41/14, G01R 31/00

(54) **Method and apparatus to detect device functionality**

(71) Applicant: Delphi Technologies Holding S.à.r.l., 4940 Bascharage (LU)
(72) Inventor: Sykes, Martin, Rainham, Kent ME8 0RB (GB); Smith, Nick, Rainham, Kent ME8 8LY (GB)
(74) Representative: Neill, Andrew Peter

(57) **Abstract**

A method of testing the operational functionality of a component (15), said component being supplied by a supply voltage V via switching means (16), comprising connecting the output of the switching means to further circuitry comprising a first resistor (R1) connected to a first reference voltage (Vcc), and a second resistor (R2) connected to a second reference voltage, and determining the voltage at a point (A) between said resistors when the switching means is in either a nominally "on" and/or an "off" state.

## Description

### Technical Field

This disclosure relates to a method and system of detecting faults in the operation and activation of electrical components and devices, and has particular but non-exclusive application to heaters and heating systems in automotive applications, such as heaters for fluids such as urea, which are used in catalytic reduction dosing systems.

### Background of the Invention

Selective Catalytic Reduction (SCR) dosing systems are systems whereby urea is dosed into the exhaust outlet of an internal combustion engine, such as a diesel engine.

In SCR systems, urea is typically injected into the exhaust system in order to reduce NOX gases. Typically provided are one of more positive temperature coefficient (PTC heaters) which are used to thaw an SCR system after a vehicle has been exposed to ambient conditions of less than -11°C (the freezing point of urea). These heaters are generally controlled by a vehicle Electronic Control Unit (ECU).

Due the high currents which are required for such heaters, it is not desirable for the ECU to control the heaters directly, as this would require high levels of power and current to be output by the ECU; ECUs are not adapted to provide such high power levels. In addition, direct control of would incur unnecessary power dissipation in the ECU.

External devices such as relays are therefore typically used to provide low cost methods to drive heaters, and these devices can be fitted close to the heaters themselves.

Failure of the heating system to thaw urea will result in the failure of the SCR system in dosing urea into the exhaust system, and the vehicle will not therefore be compliant with current exhaust emission legislation. Therefore, it is desirable (e.g. by the ECU) to diagnose failure (modes) of the heaters.

One known method to diagnose failure modes in heaters is to provide sensing devices which measure current and provide feedback to an ECU. This allows the ECU to monitor the current flowing in the heaters and therefore diagnose whether the heaters are working correctly. However, the addition of current monitoring sensors adds complexity and cost to such solutions.

It is an object of the invention to provide a simpler and less expensive method and system which enables the functionality of heaters or other devices to be monitored, and which requires minimum of hardware.

### Summary of the Invention

In one aspect is provided a method of testing the operational functionality of a component, said component being supplied by a supply voltage V via switching means, comprising connecting the output of the switching means to further circuitry comprising a first resistor connected to a first reference voltage, and a second resistor connected to a second reference voltage, and determining the voltage at a point between said resistors when the switching means is in either a nominally "on" and/or "off" state.

Preferably the said second reference voltage is ground (0V).

Preferably when said switching means is in a nominally "off" state, a fault in the operational functionality is indicated if the said determined voltage is significantly close to the bias voltage provided by said resistors and reference voltages. A fault in the operational functionality may be indicated if, when the switching means is in a nominally "off " state, the determined voltage is significantly different to ground voltage (0V). When said switching means is in a nominally "on" state, a fault in the operational functionality may be indicated if the determined voltage is significantly different from the supply voltage.

A further resistor may be located between the output of said relay and the input of said additional circuitry.

In a further aspect is provided a method of testing the operational functionality of a component, said component being supplied by a supply voltage via switching means, comprising switching said switching means "on" and/or "off" at predetermined time(s), and determining the resultant effect on the supply voltage.

A fault in the operational functionality may be indicated if there is no detectable or significant change in the supply voltage at said predetermined time(s).

The switching means may be switched on and off at a predefined frequency. The method may include measuring, detecting or analysing the frequency component of said supply voltage.

In a further aspect is provided a method of testing the operational functionality of a component, said component being supplied by a supply voltage V via first switching means and second switching means arranged in parallel, and wherein a resistor of resistance R1 is additionally located between the output of the first switching means and the input to the component, and comprising determining the voltage input to said component.

A fault may be indicated if said determined voltage differs significantly from an expected voltage.

The method may comprise setting said first switching means to a nominally "on" state and said second switching means to a nominally "off" state, and determining there is a fault if the said determined voltage is significantly different from the value V*R2/(R2+R1), where R2 is the resistance of the heater.

The method may comprise setting the first switching means to a nominally "off' state and the second switch to a nominally "on" state, and indicating there is a fault if the determined voltage is significantly different to the supply voltage.

The method may comprise setting both switching means to nominally "on" states, and determining there is a fault if the determined voltage is significantly different to the supply voltage.

The component may be a heater, such as a urea heater for a urea based catalytic system.

In yet a further aspect is provided a method of testing the operational functionality of a component or device, said component or device comprising at least two elements having resistances R1 and R2 respectively, said component being supplied by a supply voltage V via switching means, comprising determining the voltage at the point between the two elements when said component is in a nominally operational state, and indicating there is a fault if said value is significantly different to value V*R2/(R1 + R2). The switching means may be a relay.

In further aspects of the invention are provided with implement such methodology.

### Brief Description of the Drawings

The present invention will now be described, by way of example, with reference to the accompanying drawings, in which:
Figure 1 shows schematic representation of a catalytic reduction dosing system.
Figure 2 shows schematically system showing the use of relay boxes and sensors which provide diagnostic feedback.
Figure 3 shows circuitry illustrative of a basic example of the invention.
Figure 4 shows circuitry illustrative of a refined example of the invention.
Figure 5 illustrates a further example of the invention which utilizes dual relays.
Figure 6 illustrate a further example applicable to a two-part heater.

### Description of the Preferred Embodiments

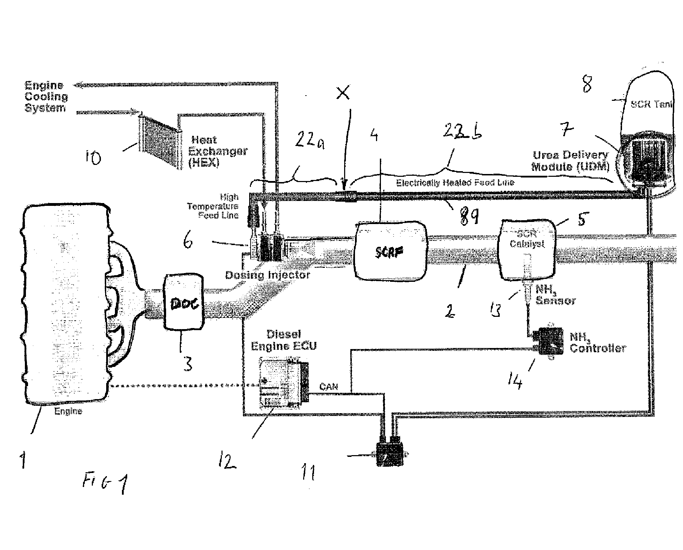

Figure 1 shows schematically the components used in a selective catalytic reduction system. It shows an engine 1 having an exhaust system 2 which includes a Diesel Oxidation Catalyst (DOC) unit 3, SCR Catalyst on Diesel Particulate unit, (SCRF) 4, as well as an SCR catalyst unit 5. A dosing injector 6 is included between the DOC and SCRF units, and is supplied from a Urea Delivery Module 7, which includes an SCR tank 8. The urea supply is via an electrically heated feed line 9. The dosing injector is adapted to inject urea into the exhaust system upstream of the SCRF unit. As the dosing injector is located adjacent to the exhaust system, in order to cool it, it is supplied with water from a (e.g. the engine) cooling system; the cooling system may include a heat exchanger/radiator 10. The dosing injector is controlled by an SCR driver module 11, which is further controlled by an engine Electronic Control Unit (ECU) 12.

When urea is injected into the exhaust, it is converted into ammonia. In the SCRF, ammonia converts NOX gases into nitrogen and water. In order to function efficiently, the SCRF unit needs to operate close to full ammonia capacity. However, as it is undesirable to emit ammonia through the exhaust, the optional SCR catalyst unit is incorporated to break down the ammonia. An ammonia sensor 13 and controller 14 may be included; these are in communication with the ECU and the SCR driver module.

In the following description, reference is made to detecting the operational functionality of devices, components or other loads, so as to, e.g., detect faults therewith. The devices may be heating devices such as urea heaters, whose proper functionality is important to ensure correct working of catalytic systems and thus ensure systems are compliant with legal obligations. The term "operational functionality" in this context is not limited to only functionality (faults) inherent in the device itself but also covers general problems such as the functionality of ancillary components such as connectors and relays.

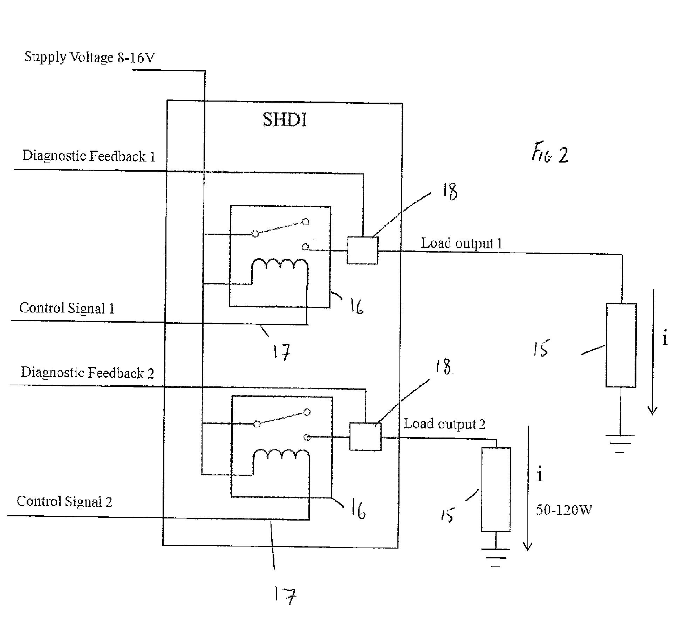

Figure 2 shows a representation of a prior art system of detecting faulty operation of heating units or other devices. In the figure, two devices such as heaters 15 are supplied by a supply voltage. Supply to the heaters is activated by relays 16 via control signals 17 from, for example, the engine control unit (ECU). In order to provide diagnostic feedback to the ECU, sensors 18 are provided which, for example, measure current and provide feedback to the ECU indicating the current flowing to/through the heaters.

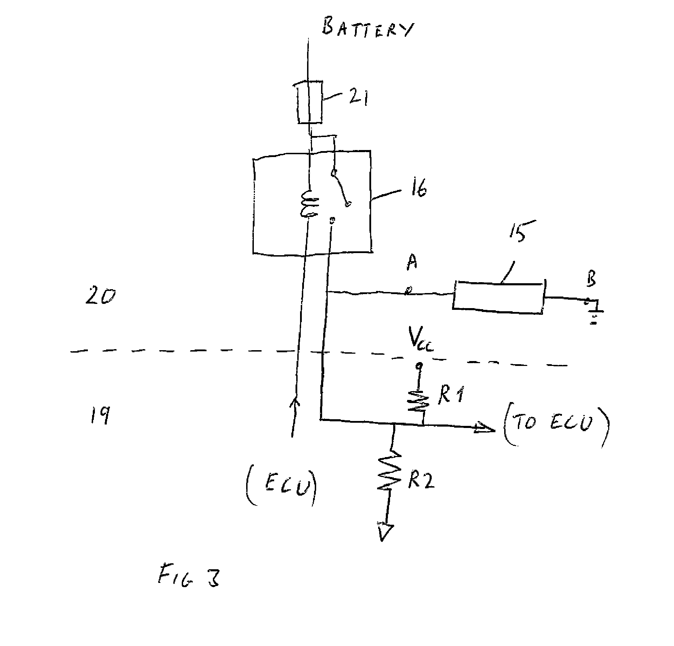

Figure 3 shows an example of circuitry used in one aspect of the invention to provide an improved and less esxpensive method of determining the operational functionality of a heater 15, i.e. to determine whether there is a fault with the heater, power supply to the heater and such like. The circuitry shown is divided by the dotted line into that portion, 19, which is located within the ECU, and that portion, 20, located outside the ECU. However, it would be clear to the skilled person that components and circuitry may be alternatively positioned in any suitable location, e.g. such that circuitry shown within the ECU may be provided as separate circuitry outside and connectable to the ECU, and vice versa. Signals from the ECU operate a relay 16 which is connected to a battery (not shown) via a fuse 21. The relay connects the power source to the heater 15 via internal switching means.

Importantly, two resistors R1 and R2 are provided connected to a first reference (supply) voltage (Vcc) and second reference voltage (which is ground, 0V) respectively, as shown. The output of the relay (i.e. the point between the resistors) is fed to an analogue input of the ECU for diagnostic purposes. The arrangement of the resistors and reference voltages means that the analogue input is thus biased towards a bias voltage of Vcc R2/(R1 + R2); the resistors can be referred to as pull-up (R1) and pull-down resistors (R2).

It is to be noted that whilst the second resistor is connected to ground, it may be connected to any suitable voltage. The term "bias voltage" would be understood to be a voltage which is intermediate between first and second reference voltages, the value dependent on the resistor values.

When a functionally working heater is connected, with the relay off, current flows through the heater and the voltage at point A (analogue input) becomes grounded. The ECU can detect the presence of a working heater by determining/measuring the voltage output from the relay and input to the ECU. If, under these conditions, the voltage input and measured by the ECU differs is significantly from 0V, a fault is indicated.

With the relay off, the battery is disconnected from the heater. When there is a fault such as a heater open circuit, there will be zero current flowing through the heater (from point A to point B) and so the value of the voltage at point A (the analogue input to the ECU) will be at the bias voltage. In this way, such a fault condition can thus be detected by the ECU and subsequently indicated. In other words, if the voltage input to the ECU is significantly close to bias voltage, a fault is indicated.

With the relay in an "on" state, if there are no faults, the analogue input should be at the power supply (battery) voltage; the ECU can thus detect that the relay has switched on correctly. If the analogue voltage input measured by the ECU is significantly different to the (battery) supply voltage, under these circumstances, a potential fault is indicated.

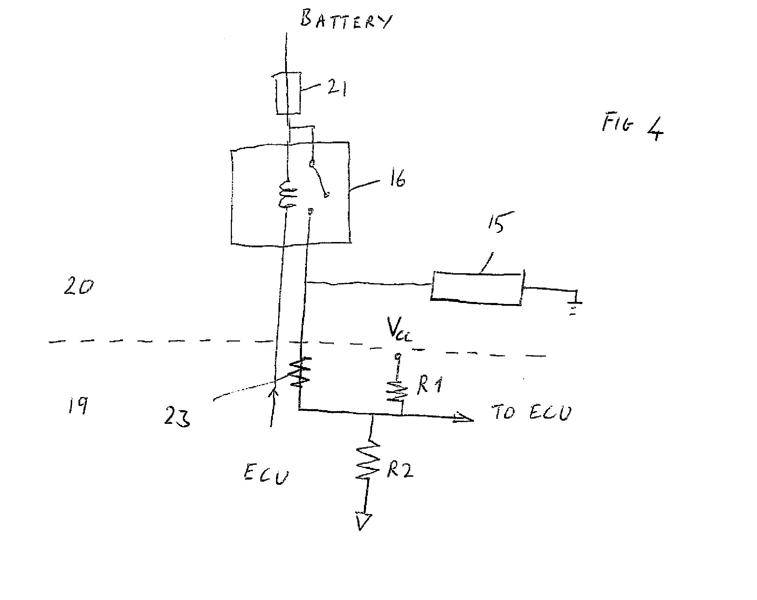

Figure 4 shows a preferred example which is similar to the above example, but it includes an additional resistor located between the relay output and the analogue input to the ECU, more specifically between point A and the analogue ECU input. This ensures that the analogue input is always kept at less than, e.g. 5 Volts, and thus the voltage at point A can be measured in all ECU states. Thus the extra resistor ensures that the voltage at point A (which is input to the ECU for measurement) is kept within a certain preferred range; thus this example provides scaled diagnostic feedback from the switch output of relay.

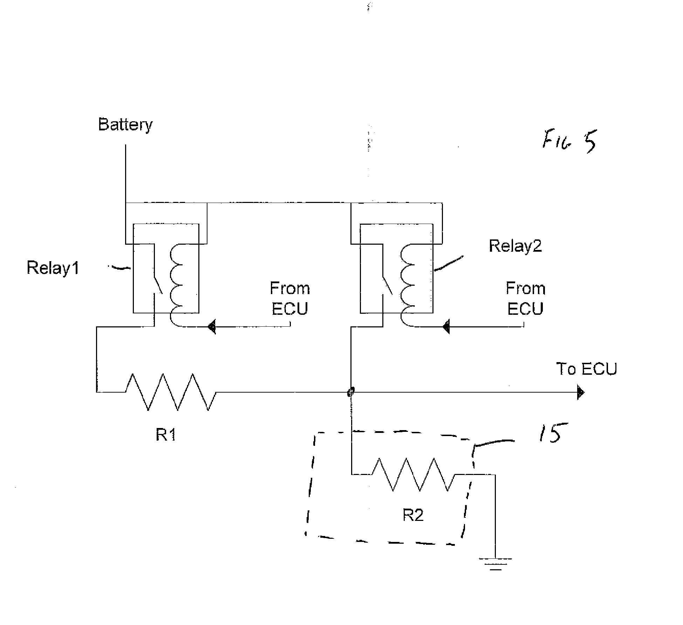

Figure 5 shows a further refined example according to a further aspect. A first relay, Relay 1, and a second relay, Relay 2, are connected in parallel to the power source such as a vehicle battery. Both relays are controlled by, for example, the ECU. The output of the first relay is supplied to the ECU, via a first resistor, R1, for diagnostic purposes. The output of the second relay is output to the heater 15, which is shown as resistance R2; in other words the heater has a resistance R2. Although in the example two relays are shown, any type of appropriate switching means may be used for example to provide the functionality of the relays.

As mentioned the output from R1 is input to the ECU which can determine the operational state of the heater by appropriate analysis of the voltage existing at this output under various conditions.

Table 1 below shows an example(s) illustrate how such an arrangement can perform a checking/diagnosis of the operational state of the heater. With both relays in an "off" state, the voltage feedback to the ECU (output from R1) should be zero volts. Any significant deviation in actual and expected values of the voltage feedback to the ECU would indicate a fault.

Where first relay is in an "on" state and second relay is in an "off" state, the voltage input to the ECU should ideally be (if there are no faults) the voltage of the battery/supply multiplied by a factor R2/(R1 + R2). The value of R2 (the heater resistance) can be determined/estimated previously; i.e. it is known beforehand.

When the heater is switched on and the first relay is in an "off" state and the second relay in an "on" state, the voltage input to the ECU should be at the supply (battery) voltage. When both relays are in an "on" position, the input to the ECU should also be at battery voltage.

If any of the inputs to the ECU deviate from these expected values, it indicates there is a fault in the operational state of the heater.

**Table 1**

| | | | | |
|---|---|---|---|---|
| | OFF | DIAG | HEATER ON | Unused state |
| RELAY 1 | OFF | ON | OFF | ON |
| RELAY 2 | OFF | OFF | ON | ON |
| ECU FEEDBACK | 0v | Battery*R2/(R1+R2) | Battery Volts | Battery Volts |

Hereinafter, further examples of the invention will be described.

Referring generally to the figures, when a correctly functioning device (such as a heater) is connected, there will be a slight power drop in the battery which can be detected as a slight voltage drop across the battery terminals. Thus, actuation of heaters and other devices will change the load on the battery and this can be seen as consequential changes in voltage across battery or alternator. According to one aspect, the voltage drop across the battery terminals/alternator can be monitored or measured by the ECU to indicate operational functionality of components/devices.

In one example, the method involves simply analyzing battery voltage changes in response to operationally connecting a load such as heater, i.e. switching on/off a device or component. This may be consequent to actuating a relay. In such simple examples, the device is simply switched on (i.e. to a nominally operational state) and any subsequent voltage drop determined.

However, in automotive applications, as battery power is used by a multiplicity of systems and devices, it may not be clear that the battery response is necessarily due to connecting of a particular device (e.g. heater) under analysis. Battery voltage will also have a natural fluctuation; voltage drops may arise due to operation of spark plugs, for example, or more random events such as switching on lights will also have an effect. In preferred examples, therefore, the device under investigation may be connected, then disconnected (by switching the appropriate relay on and off) more than once, say at predetermined times, and the resultant effect on battery voltage analysed.

In a further particularly advantageous embodiment, the devices/components under investigation are actuated (e.g. switched on and off via a relay) at a defined (particular) frequency, and any consequential battery/alternator voltage changes analysed, such as the frequency characteristics of the battery voltage. In this way, it is possible to distinguish clearly what the effects of connecting the particular device (e.g. heater) are, due to the presence of this frequency in the battery voltage. It is to be noted that in alternative embodiments, where the effects on battery voltage are determined, alternator voltage/load signals can be measured for analysis instead, as they will show consequential changes also. Thus, any reference to detecting, analyzing or measure changes in the supply voltage, or frequency component thereof, are to be understood to include detecting, analyzing or measuring changes in the alternator voltage or voltage of any other appropriate (e.g. automotive) component.

In summary, actuation of, e.g. heaters, will change the load on the battery/alternator, and this can be seen on the battery voltage or the load on the alternator (these parameters can be read by the ECU). By actuating the loads at a defined frequency it is possible to sense whether the devices are working due to the presence of this frequency in the battery voltage or alternator load signals. Thus the problems of other loads also impacting the battery/alternator load voltages are overcome.

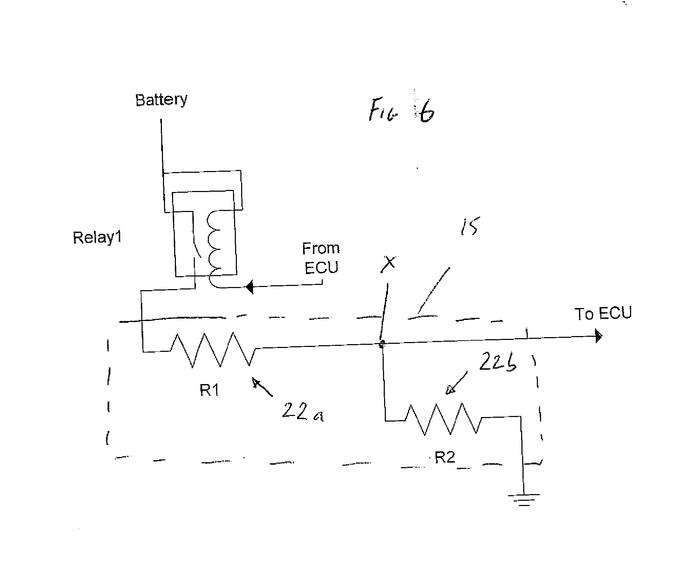

Figure 6 shows a further example illustrative of a method which is applicable to, for example, two-part heaters. Two-part heaters typically comprise two heater elements connected in series. Specifically, urea heaters for automotive applications are often provided by heating coils which extend along a feed line/pipe.

For example, with reference to figure 1, a urea heater may be located along the length of the feed line, comprising two-heating portions/elements (22a, 22b), each having a particular resistance. Thus, the heater can be represented (as in figure 6) comprising two resistances R1 and R2, corresponding to the heating elements 22a and 22b of figure 1. The heater, as before, is supplied with power from the battery via a switchable relay, controlled by the ECU. At point "X" on figure 1, the two portions of the heater and feed line are connected, so such a point is also a convenient location to determine intermediate voltage between the two heater portion elements for diagnostic purposes.

In one aspect, if the heater is working correctly, the voltage at the mid-point "X", which is fed to the ECU and measured, should be substantially close to the value V*R2/(R2 + R1), where V is the supply/battery voltage. Any significant deviation from this value would indicate a fault.

The terms "significant deviation", "significant deviation", "significant difference", "significantly close/same" would be readily understood by the skilled person, who would also know how to implement these terms practically. For example, any differences/deviations may be compared with a predetermined threshold, and faults indicated if they are larger or equal to this threshold. The threshold may be determined by appropriate testing.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. A method of testing the operational functionality of a component, said component being supplied by a supply voltage V via switching means, comprising connecting the output of the switching means to further circuitry comprising a first resistor connected to a first reference voltage, and a second resistor connected to a second reference voltage, and determining the voltage at a point between said resistors when the switching means is in either a nominally "on" and/or "off" state.

2. A method as claimed in claim 1 where said second reference voltage is ground (0V).

3. A method as claimed in claim 1 or 2 wherein, when said switching means is in a nominally "off" state, indicating a fault in the operational functionality if the said determined voltage is significantly close to the bias voltage provided by said resistors and reference voltages.

4. A method as claimed in claims 1 or 2 wherein a fault in the operational functionality is indicated if, when the switching means is in a nominally "off " state, the determined voltage is significantly different to ground voltage (0V).

5. A method as claimed in claims 1 or 2 wherein when said switching means is in a nominally "on" state, a fault in the operational functionality is indicated if the determined voltage is significantly different from the supply voltage.

6. A method as claimed in any preceding claim including providing a further resistor between the output of said relay and the input of said additional circuitry.

7. A method as claimed in claim 1 to 6 wherein said further circuitry is part of a vehicle Electronic Control Unit.

8. A method of testing the operational functionality of a component, said component being supplied by a supply voltage via switching means, comprising switching said switching means "on" and/or "off" at predetermined time(s), and determining the resultant effect on the supply voltage.

9. A method as claimed in claimed in claim 8 including indicating there is a fault in the operational functionality if there is no detectable or significant change in the supply voltage at said predetermined time(s).

10. A method as claimed in claims 8 or 9 wherein said switching means is switched on and off at a predefined frequency.

11. A method as claimed in claims 8 to 10 including measuring, detecting or analysing the frequency component of said supply voltage.

12. A method of testing the operational functionality of a component, said component being supplied by a supply voltage V via first switching means and second switching means arranged in parallel, and wherein a resistor of resistance R1 is additionally located between the output of the first switching means and the input to the component, and comprising determining the voltage input to said component.

13. A method as clamed in claim 12 comprising indicating a fault if said determined voltage differs significantly from an expected voltage.

14. A method as claimed in claims 12 or 13, comprising setting said first switching means to a nominally "on" state and said second switching means to a nominally "off" state, and determining there is a fault if the said determined voltage is significantly different from the value V*R2/(R2+R1), where R2 is the resistance of the heater.

15. A method as claimed 12 or 13 comprising, setting the first switching means to a nominally "off" state and the second switch to a nominally "on" state, and indicating there is a fault if the determined voltage is significantly different to the supply voltage.

16. A method as claimed in claims 12 or 13 comprising setting both switching means to nominally "on" states, and determining there is a fault if the determined voltage is significantly different to the supply voltage.

17. A method as claimed in claims 1 to 16 wherein said component is a heater.

18. A method as claimed in claim 17 wherein said heater is a urea heater for a urea based catalytic system.

19. A method of testing the operational functionality of a component or device, said component or device comprising at least two elements having resistances R1 and R2 respectively, said component being supplied by a supply voltage V via switching means, comprising determining the voltage at the point between the two elements when said component is in a nominally operational state, and indicating there is a fault if said value is significantly different to value V*R2/(R1 + R2),

20. A method as claimed in claims 1 to 19 wherein said switching means is a relay.

21. A system for testing the operational functionality of a component, said component being supplied by a supply voltage V via switching means, comprising means to connect the output of the switching means to further circuitry comprising a first resistor connected to a first reference voltage, and a second resistor connected to a second reference voltage, and means to determine the voltage at a point between said resistors when the switching means is in either a nominally "on" and/or an "off" state.

22. A system as claimed in claim 21 wherein, where said second reference voltage is ground (0V).

23. A system as claimed in claim 21 or 22 having means to set said switching means to a nominally "off" state, and means to indicate a fault in the operational functionality of said component if the determined voltage is significantly close to the bias voltage provided by said resistors and reference voltages.

24. A system as claimed in claims 21 or 22 having means to indicate a fault if, when the switching means is in a nominally "off" state, the determined voltage is significantly different from ground voltage (0V).

25. A system as claimed in claims 21 or 22 having means to set said switching means to a nominally "on" state, and means to indicate a fault if the determined voltage is significantly different from the supply voltage.

26. A system as claimed in claims 20 to 25 including a further resistor located between the output of said relay and the input of said additional circuitry.

27. A system as claimed in claims 21 to 26 wherein said further circuitry is part of a vehicle Electronic Control Unit.

28. A system of testing the operational functionality of a component, said component being supplied by a supply voltage via switching means, comprising means to switch said switching means on and/or off at predetermined time(s), and means to determine the resultant effect on the supply voltage.

29. A system as claimed in claimed in claim 28 comprising means to indicate there is a fault in the operational functionality of said component if there is no detectable or significant change in supply voltage at said predetermined time(s).

30. A system as claimed in claims 28 or 29 having means to switch said switching means on and off at a predefined frequency.

31. A system as claimed in claims 28 to 30 including means to detect, analyse or measure the frequency component of said supply voltage.

32. A system of testing the operational functionality of a component, said component being supplied by a supply voltage V via first switching means and second switching means arranged in parallel, and wherein a resistor of resistance R1 is additionally located between the output of the first switching means and the input to the component, and means to determining the voltage input to said component.

33. A system as clamed in claim 32 comprising means to indicate a fault if said determined voltage differs significantly from an expected voltage.

34. A system as claimed in claims 32 or 33 comprising means to set said fist switching means to an "on" state and said second switching means to an "off" state, and determining there is a fault if the determined voltage is significantly different from the value V*R2/(R2+R1), where R2 is the resistance of the heater.

35. A system as claimed 32 or 33 comprising, when the component is in a nominally operational state, means to set the first switch to a nominally "off" state and the second switch to a nominally "on" state and means to indicate there is a fault if the determined voltage is significantly different to the supply voltage.

36. A system as claimed in claims 32 or 33 comprising means to set the component in a nominally non-operational state, both switches to an "on" state, and means to determine there is a fault if the determined voltage is significantly different to the supply voltage.

37. A system as claimed in claims 21 to 36 wherein said component is a heater.

38. A system as claimed in claim 37 wherein said heater is a urea heater for a urea based catalytic system.

39. A system of testing the operational functionality of a component comprising at least two elements having resistances R1 and R2 respectively, said component being supplied by a supply voltage V via switching means, comprising means to determine the voltage at the point between the two elements when said component is in a nominally operational state, and means to indicate there is a fault if said value is significantly different to value V*R2/(R1 + R2).

40. A system as claimed in claims 21 to 39 wherein said switching means is a relay.
